**Europäisches Patentamt**

**European Patent Office**

**Office européen des brevets**

(19)

(11) Numéro de publication : **0 342 095 B1**

## (12) FASCICULE DE BREVET EUROPEEN

(45) Date de publication du fascicule du brevet :
**16.09.92 Bulletin 92/38**

(51) Int. Cl.⁵ : **H05K 7/14**

(21) Numéro de dépôt : **89401222.8**

(22) Date de dépôt : **28.04.89**

(54) **Dispositif de protection mécanique de plaque de circuit imprimé, en particulier de châssis de téléviseur en couleurs.**

(30) Priorité : **10.05.88 FR 8806279**

(43) Date de publication de la demande :
**15.11.89 Bulletin 89/46**

(45) Mention de la délivrance du brevet :
**16.09.92 Bulletin 92/38**

(84) Etats contractants désignés :
**DE FR GB IT**

(56) Documents cités :
**DE-A- 2 849 297**
**DE-A- 2 853 367**
**US-A- 4 048 669**

(73) Titulaire : **SOCIETE ELECTRONIQUE DE LA REGION PAYS DE LOIRE**
**74, rue du Surmelin**
**F-75020 Paris (FR)**

(72) Inventeur : **Huerre, Dominique**
**Thomson-CFS SCPI-Cedex 67**
**F-92045 Paris La Defense (FR)**

(74) Mandataire : **Chaverneff, Vladimir et al**
**THOMSON-CSF SCPI**
**F-92045 PARIS LA DEFENSE CEDEX 67 (FR)**

EP 0 342 095 B1

Jouve, 18, rue Saint-Denis, 75001 PARIS

**Description**

La présente invention se rapporte à un dispositif de protection mécanique de plaque de circuit imprimé, en particulier de châssis de téléviseur en couleurs.

La plupart des composants électroniques, autres que le tube cathodique, d'un téléviseur sont actuellement disposés sur une seule grande plaque de circuit imprimé. Les normes d'essais de résistance mécanique de telles plaques, montées dans le coffret du téléviseur, prévoient en particulier des épreuves de chute consistant à faire tomber le téléviseur d'une hauteur de 60 cm environ. Pour permettre à ces plaques de résister à de tels chocs, on les enserre dans un cadre rigide fixé solidement au coffret du téléviseur. Un tel cadre masque une partie du circuit imprimé, ce qui en complique la maintenance. En outre, ce cadre n'empêche pas toujours la rupture ou la fissuration de la plaque de circuit imprimé, et la chute peut provoquer un déplacement du cache arrière par rapport au coffret, et donc par rapport à la plaque de circuit imprimé supportant entre autre les connecteurs du téléviseur tels que la prise "Péritel" et la prise d'antenne.

La présente invention a pour objet un dispositif de protection mécanique de plaque de circuit imprimé, de forme générale rectangulaire, disposée dans un coffret comportant une cloison latérale amovible, un des côtés de la plaque étant proche et parallèle à cette cloison amovible, dispositif de protection qui soit simple à réaliser et à mettre en place, tout en garantissant une très bonne résistance de la plaque aux chocs, tels qu'une très forte décélération, ou aux vibrations, et qui évite tout déplacement relatif de la plaque par rapport à ladite cloison amovible. En outre, ce dispositif doit masquer le moins possible les composants et les circuits imprimés de la plaque.

Le dispositif de protection mécanique conforme à l'invention comporte un étrier en "U" se composant d'une partie centrale et de deux branches enserrant la plaque sur les trois côtés non proches de la cloison amovible, cet étrier comportant à sa partie antérieure au moins deux pieds en forme de "L" pénétrant librement dans des trous correspondants pratiqués dans le fond du coffret, chaque extrémité de l'étrier coopérant avec un dispositif de guidage et de maintien à pivotement limité formé sur la cloison amovible, avantageusement un dispositif de fixation par encliquetage. Selon un aspect avantageux de l'invention, on dispose sur le quatrième côté de la plaque un raidisseur qui est fixé, de préférence par encliquetage, à l'étrier.

Selon un autre aspect avantageux de l'invention, s'appliquant en particulier aux châssis de téléviseurs ou de moniteurs, on forme sur au moins une des branches de l'étrier un bossage cylindrique circulaire qui peut être introduit dans un trou correspondant pratiqué dans une paroi du coffret pour maintenir le châssis en position de dépannage.

La présente invention sera mieux comprise à la lecture de la description détaillée d'un mode de réalisation, pris comme exemple non limitatif, et illustré par le dessin annexé, sur lequel :

– la figure 1 est une vue de dessus d'une plaque de circuit imprimé munie d'un dispositif de protection conforme à un mode de réalisation avantageux de l'invention, en position normale dans un boîtier ;

– la figure 2 est une coupe selon II-II de la figure 1, et

– la figure 3 est une vue simplifiée en perspective de la plaque de la figure 1 en position de dépannage.

L'invention est décrite ci-dessous en référence à une plaque de circuit imprimé comportant l'essentiel des circuits électroniques d'un téléviseur ou d'un moniteur, mais il est bien entendu que l'invention n'est pas limitée à une telle application, et qu'elle peut être mise en oeuvre dans pratiquement tout équipement comportant une plaque relativement mince sur laquelle sont fixés des composants, dont certains doivent être accessibles à travers des ouvertures d'une cloison amovible fixée sur le coffret renfermant cet équipement, cet équipement devant pouvoir résister à des chocs ou à des vibrations.

Dans le cas présent, la cloison amovible est le cache arrière du téléviseur, et les composants qui doivent être accessibles à travers cette cloison sont des connecteurs d'entrée et de sortie du châssis. Ces composants pourraient également être des composants réglables de l'extérieur à l'aide d'un tournevis ou d'un outil approprié, tels que des potentiomètres. La plaque mince supportant des composants est le "châssis" du téléviseur, c'est-à-dire le circuit imprimé comportant la quasi-totalité des circuits électroniques du téléviseur (des circuits tels que les circuits de réglage d'accord et d'affichage de stations peuvent être disposés sur un petit circuit imprimé annexé fixé séparément sur le boîtier du téléviseur ou sur sa façade).

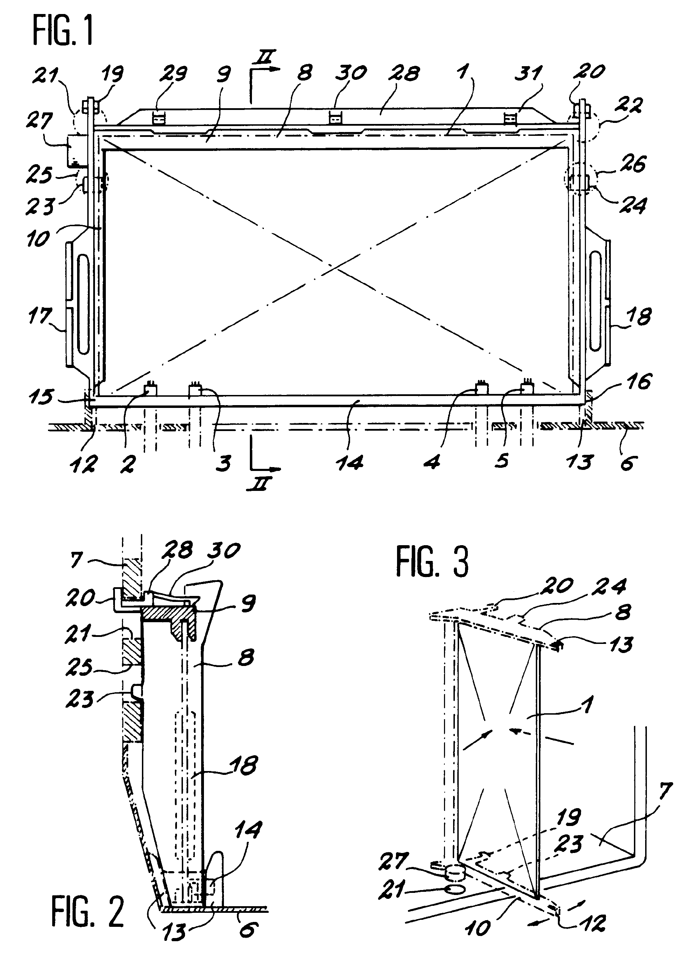

Le châssis 1 du téléviseur est une plaque de circuit imprimé de forme rectangulaire qui n'a pas été représentée en détail sur le dessin. Le châssis 1 porte des connecteurs permettant de relier le téléviseur à l'environnement extérieur : secteur d'alimentation, antenne, démodulateur de signaux transmis par satellite, etc... Sur la figure 1, on a représenté schématiquement quatre tels connecteurs, référencés 2 à 5, qui sont, dans le cas présent, fixés sur la face supérieure du châssis 1, répartis le long de son grand côté arrière (c'est-à-dire son grand côté le plus proche du cache arrière 6).

Pour assurer à la fois la fixation du châssis 1 dans le coffret 7 du téléviseur et sa rigidification, on le munit d'un dispositif support 8 en "U" qui l'entoure sur trois côtés (à l'exception de son grand côté arrière).

Ce dispositif support 8 se compose d'une partie centrale 9 et de deux branches 10,11 et il est avantageusement réalisé en matière plastique sous forme générale d'un profilé à section en "F". Les deux petites branches en "F" forment une gouttière dans laquelle viennent se loger à frottement doux les rebords du châssis 1, et la grande branche (verticale) du "F" est assez longue pour que la plaque 1 soit suffisamment distante du fond 7 du coffret lorsque le support 8 repose sur ce fond 7, la plaque 1 étant en place dans le support 8. Le support 8 peut même être relativement souple en flexion (forces dirigées parallèlement au plan du châssis 1), et peut donc être relativement mince et léger, ce qui le rend peu onéreux.

Les extrémités des branches 10 et 11 du support 8 viennent s'engager dans des guides 12,13 formés intégralement avec le cache arrière 6 qui les retiennent latéralement (dans le sens des grands côtés du châssis 1) mais leur permettent un léger débattement (d'environ 10 à 20°) dans le sens d'un pivotement vertical autour des extrémités de ces branches.

Afin de rigidifier la plaque 1 sur son côté non protégé par le support 8, on clipse un raidisseur 14 sur ce côté. Ce raidisseur peut par exemple être un profilé en matière plastique à section en "F" ou en "I" dont les extrémités 15,16, pourvues de dispositifs d'encliquetage appropriés, s'encliquètent sur les branches 10,11 respectivement du support 8. La largeur du raidisseur 14 et la longueur des branches 10,11 sont telles qu'il subsiste entre ce raidisseur et le cache 6 un jeu d'environ 5 mm lorsque les branches 10,11 sont encliquetées dans le cache 6.

Pour faciliter la manipulation de la plaque 1, on forme sur les faces extérieures des branches 10,11 des poignées 17,18.

Sur les branches 10,11, près de leur jonction avec la partie 9 du support 8, on forme des pattes 19,20 en forme de "L" faisant saillie vers le bas. Les grandes branches de ces "L" sont perpendiculaires au plan de la plaque 1, et leurs petites branches lui sont parallèles. D'autre part, on pratique dans la paroi 7 des trous 21,22 pour le passage de ces pattes. Le diamètre de ces trous est supérieur à la longueur des petites branches des "L" des pattes 19,20. Les dimensions des grandes branches des "L" formés par les pattes 19,20 et la disposition de ces pattes par rapport au support 8 sont telles que lorsque le support 8 est en place, les branches courtes des "L" sont appliquées contre la face inférieure de la paroi 7. Pour mieux maintenir en place le support 8, on forme sur les branches 10,11, en arrière des pieds 19 et 20, des tétons 23,24 respectivement qui font saillie vers le bas et viennent se loger dans des trous 25,26 pratiqués dans la paroi 7. De façon avantageuse, les trous 25,26 ont le même diamètre et le même entraxe que les trous 21,22 pour permettre d'y introduire et maintenir les pattes 19,20 afin de pouvoir placer la plaque 1 en position reculée dans le coffret du téléviseur et avoir un meilleur accès à ses composants, par exemple pour un réglage.

Pour mettre en place la plaque 1 avec son support 8, on la présente légèrement en biais de façon à pouvoir introduire facilement les pattes 19,20 dans les trous 21,22 et à pouvoir faire passer les tétons 23,24. Lorsque les branches longues des pattes 19,20 sont en butée contre la partie antérieure des trous 21,22, on bascule la plaque 1 pour la rendre parallèle à la paroi 7, les tétons 23,24 viennent se loger dans les trous 25,26 en butée contre leur génératrice postérieure. On met ensuite en place le cache arrière 6 qui se fixe, par exemple par encliquetage, sur le coffret, et simultanément vient se fixer sur les dispositifs d'encliquetage 12,13 du support 8. Dans le cas où l'on utilise le raidisseur 14, on le monte bien entendu avant de mettre en place la plaque 1 dans le coffret.

Sur une des branches 10 ou 11 du support 8, ou même sur les deux, on peut avantageusement former un bossage 27 en forme de court cylindre à section circulaire. Dans l'exemple représenté, ce bossage est formé sur la branche 10, près de sa jonction avec la partie 9. Le diamètre extérieur du bossage 27 est sensiblement égal au diamètre des trous 21,22 ou 25,26. Grâce à ce bossage 27 que l'on peut introduire dans un de ces trous, ou éventuellement dans un autre trou de même diamètre pratiqué en un endroit approprié du coffret, on peut placer la plaque 1 avec son support 8 en position de dépannage, comme par exemple représenté en figure 3. Les circuits de la plaque sont ainsi bien visibles et facilement accessibles, et la plaque peut rester reliée aux autres éléments du téléviseur (tube cathodique, clavier de commande, etc...).

De façon avantageuse, on peut former sur la partie 9 du support 8, à l'extérieur de ce support (par rapport à la plaque 1), une passerelle 28 servant de chemin de câbles pour les câbles (non représentés) reliant les circuits de la plaque 1 à d'autres élément du téléviseur. Pour bien maintenir en place ces câbles, on forme sur la pièce 9 des pinces de clipsage telles que les pinces 29 à 31 représentées sur le dessin.

Ainsi, le dispositif de protection de l'invention permet de tenir en place le châssis 1 dans le coffret du téléviseur en assurant le positionnement correct des prises 2 à 5 par rapport aux trous du cache, ce dispositif de protection établissant une liaison par articulation (grâce aux pieds 19,20 en "L") entre le châssis 1 et le coffret, n'exerçant pas de contraintes sur le châssis dans toutes ses conditions d'utilisation. En outre, la mise en place et le démontage du châssis dans le coffret sont très simplifiés.

## Revendications

1. Dispositif de protection mécanique de plaque de circuit imprimé (1), en particulier de châssis de télévision en couleurs, disposée dans un coffret (7) comportant une cloison latérale amovible (6), un des côtés de la plaque, de forme générale rectangulaire, étant proche de, et parallèle à cette cloison amovible, caractérisé par le fait que ce dispositif de protection comporte un étrier (8), en "U" se composant d'une partie centrale (9) et de deux branches (10,11) enserrant la plaque sur les trois côtés non proches de la cloison amovible, cet étrier comportant à sa partie antérieure au moins deux pieds en forme de "L" (19,20) pénétrant librement dans des trous correspondants (21,22) pratiqués dans le fond (7) du coffret, chaque extrémité des branches de l'étrier coopérant avec un dispositif (12,13) de guidage et de maintien à pivotement limité formé sur la cloison amovible.

2.  Dispositif de protection selon la revendication 1, caractérisé par le fait que l'on clipse sur le quatrième côté de la plaque un raidisseur (14).

3.  Dispositif de protection selon la revendication 2, caractérisé par le fait que le raidisseur est fixé par encliquetage à l'étrier (15,16).

4.  Dispositif de protection selon l'une des revendications précédentes, caractérisé par le fait que l'on forme sur au moins l'une des branches (10,11) de l'étrier un bossage cylindrique circulaire (27) qui peut être introduit dans un trou correspondant pratiqué dans une paroi du coffret (7) pour maintenir la plaque en position de dépannage (figure 3).

5.  Dispositif selon l'une des revendications précédentes, caractérisé par le fait que l'on forme sur les deux branches de l'étrier des tétons (23,24) faisant saillie vers le bas et venant se loger dans des trous (25,26) pratiqués dans la paroi (7) de fond du coffret pour mieux maintenir en place la plaque dans le coffret.

6.  Dispositif de protection selon l'une des revendications précédentes, caractérisé par le fait que l'on forme sur la partie centrale (9) de l'étrier un chemin de câbles (28) et des pinces de clipsage de câbles (29 à 31).

**Patentansprüche**

1.  Vorrichtung für den mechanischen Schutz einer gedruckten Schaltungskarte (1), insbesondere einer Farbfernseher-Platine, die in einem Gehäuse (7) angeordnet ist, das eine entfernbare Seitenwand (6) aufweist, wobei eine der Seiten der Karte, welche allgemein rechteckförmig ist, nahe bei dieser entfernbaren Wand und parallel zu dieser gelegen ist, dadurch gekennzeichnet, daß diese Schutzvorrichtung einen "U"-förmigen Bügel (8) umfaßt, der aus einem zentralen Teil (9) und zwei Schenkeln (10, 11) besteht und zwischen denen die Karte auf drei Seiten eingespannt ist, die der entfernbaren Wand nicht benachbart liegen, wobei dieser Hügel an seinem vorderen Teil wenigstens zwei "L"-förmige Fußstücke (19, 20) aufweist, die frei in entsprechende Löcher (21, 22) eindringen, die in dem Boden (7) des Gehäuses gebildet sind, wobei jedes Ende der Schenkel des Bügels mit einer auf der entfernbaren Wand gebildeten Vorrichtung (12, 13) zur Führung und zum Halten mit begrenzter Verschwenkung zusammenwirkt.

2.  Schutzvorrichtung nach Anspruch 1, dadurch gekennzeichnet, daß an der vierten Seite der Karte ein Versteifungselement (14) eingeklipst wird.

3.  Schutzvorrichtung nach Anspruch 2, dadurch gekennzeichnet, daß das Versteifungselement durch Schnappbefestigung an dem Bügel (15, 16) festgelegt ist.

4.  Schutzvorrichtung nach einem der vorstehenden Ansprüche, dadurch gekennzeichnet, daß an wenigstens einem der Schenkel (10, 11) des Bügels ein kreisrunder zylindrischer Vorsprung (27) gebildet wird, der in ein entsprechendes Loch eingeführt werden kann, welches in einer Wandung des Gehäuses (7) angebracht ist, um die Karte in Wartungsstellung (Fig. 3) zu halten.

5.  Vorrichtung nach einem der vorstehenden Ansprüche, dadurch gekennzeichnet, daß an den zwei Schenkeln des Bügels Zapfen (23, 24) gebildet werden, die nach unten hin vorstehen und in Löchern (25, 26) aufgenommen werden, die in der Bodenwand (7) des Gehäuses angebracht sind, um der Karte in dem Gehäuse einen besseren Halt zu verschaffen.

6.  Schutzvorrichtung nach einem der vorstehenden Ansprüche, dadurch gekennzeichnet, daß an dem zentralen Teil (9) des Bügels eine Kabeldurchführung (28) und Kabelklemmen (29 bis 31) gebildet sind.

**Claims**

1.  Device for mechanical protection of a printed circuit board (1), in particular of a colour-television chassis, arranged in a cabinet (7) comprising a removable lateral partition (6), one of the sides of the board, of general rectangular shape, being close to and parallel with this removable partition, characterised in that this protection device comprises a "U"-shaped stirrup piece (8), composed of a central portion (9) and of two branches (10, 11), surrounding the board on the three sides away from the removable partition, this stirrup piece comprising, at its front part, at least two "L"-shaped feet (19, 20) penetrating freely into corresponding holes (21, 22) made in the base (7) of the cabinet, each end of the branches of the stirrup piece interacting with a guiding and holding device (12, 13) with limited pivoting which is formed on the removable partition.

2. Protection device according to Claim 1, characterised in that a stiffener (14) is clipped onto the fourth side of the board.

3. Protection device according to Claim 2, characterised in that the stiffener is snap-fitted to the stirrup piece (15, 16).

4. Protection device according to one of the preceding claims, characterised in that a circular cylindrical projection (27), which can be inserted into a corresponding hole made in a wall of the cabinet (7) to hold the board in position for repair (Figure 3) is formed on at least one of the branches (10, 11) of the stirrup piece.

5. Device according to one of the preceding claims, characterised in that studs (23, 24) projecting downwards and being housed in holes (25, 26) made in the base wall (7) of the cabinet in order to improve holding in position of the board in the cabinet are formed on the two branches of the stirrup piece.

6. Protection device according to one of the preceding claims, characterised in that a cable way (28) and cable clips (29 to 31) are formed on the central part (9) of the stirrup piece.

# FIG. 1

# FIG. 2

# FIG. 3